# EUROPEAN PATENT SPECIFICATION

(11) **EP 2 139 970 B1**
(45) Date of publication and mention of the grant of the patent: **24.09.2014**
(21) Application number: 08753265.1
(22) Date of filing: 30.04.2008
(51) Int. Cl.: H01L 51/50, H01L 51/00

(54) **ORGANIC LIGHT EMITTING DEVICE AND METHOD OF PRODUCING THE SAME**
ORGANISCHES LICHTEMITTIERENDES GERÄT UND HERSTELLUNGSVERFAHREN DAFÜR
DISPOSITIF ORGANIQUE ÉLECTROLUMINESCENT ET SON PROCÉDÉ DE PRODUCTION

(30) Priority: 30.04.2007 KR 20070042085
(43) Date of publication of application: 06.01.2010
(73) Proprietor: LG Chem, Ltd., Seoul 150-721 (KR)
(72) Inventor: NOH, Jeoung-Kwen, Daejeon Metropolitan City 305-340 (KR); KANG, Min-Soo, Daejeon Metropolitan City 305-756 (KR); KIM, Jong-Seok, Seoul 140-030 (KR); KIM, Kong-Kyeom, Daejeon Metropolitan City 305-761 (KR)
(74) Representative: Goddar, Heinz J.
(86) International application number: PCT/KR2008/002465
(87) International publication number: WO 2008/133483

(56) References cited:
- EP-A1- 1 722 604
- EP-A1- 1 734 038
- EP-A2- 0 949 696
- WO-A1-2007/018004
- US-A1- 2003 165 715
- US-A1- 2003 168 970
- US-A1- 2005 255 334
- US-A1- 2007 069 638
- US-B1- 6 420 057
- US-B2- 6 790 540
- US-B2- 6 800 380
- US-B2- 6 849 348

## Description

### [Technical Field]

The present invention relates to an organic light emitting device and a method of producing the same. More particularly, the present invention relates to an organic light emitting device that does not affect electron injecting and transporting properties, has excellent organic light emitting device properties, and is produced by using a simple process, and a method of producing the same. This application claims priority from Korea Patent Application No. 10-2007-0042085 filed on April 30, 2007 in the KIPO.

### [Background Art]

Generally, the term "organic light emitting phenomenon" refers to a phenomenon in which electric energy is converted to light energy by using an organic material. An organic light emitting device using the organic light emitting phenomenon typically includes an anode, a cathode, and an organic material layer that is interposed between the anode and the cathode. The organic material layer is to have a multi layered structure made of different material in order to improve efficiency and stability of the organic light emitting device. For example, the organic material layer may be formed of a hole injection layer, a hole transporting layer, a light emitting layer, an electron transporting layer, an electron injection layer, and the like. If voltage is applied between two electrodes in the organic light emitting device having the above-mentioned structure, a hole is injected into the organic material layer at an anode and an electron is injected into the organic material layer at a cathode. When the hole meets the electron, an exciton is generated, and light is generated when the exciton is converted into a bottom state. It is known that the organic light emitting device has properties such as self-light emission, high luminance, high efficiency, a low driving voltage, a wide viewing angle, high contrast, and a high-speed response.

The materials used for the organic material layer of the organic light emitting device may be classified into a light emitting material and a charge transporting material, for example, a hole injecting material, a hole transporting material, an electron transporting material, and an electron injecting material according to the type of function.

In order to allow the organic light emitting device to fully exhibit the above-mentioned excellent characteristics, a material constituting the organic material layer in the device, for example, a hole injecting material, a hole transporting material, a light emitting material, an electron transporting material, and an electron injecting material should be essentially composed of a stable and efficient material. However, the development of a stable and efficient organic material layer material for the organic light emitting device has not yet been fully realized. Accordingly, the development of new materials is continuously desired.

US 2007/069638 A1 discloses an organic electroluminescence device comprising an electron transporting layer comprising an electron transporting compound being possibly an oxazole derivative, an imidazole derivative, a benzothiazole derivative, a metal compound of a 8-quinolinol derivative or a metal complex having benzothiazole as a ligand. The electron transporting compound preferably comprises a benzimidazole ring. The electron transporting layer may include a reducing dopant such as an alkali metal halide or oxide or a metal complex, and LiF, NaF or CaO are given as examples. A hole transporting/injection layer may be added to the device. The electron transporting layer is in direct contact with a cathode. The electron transporting/injection material may be co-deposited with the reducing dopant at a molar ratio of 1:5 to 5:1.

In EP 1 734 038 A1 a material for an EL device realizing an organic EL device capable of having a high current efficiency even at a low voltage is provided. The OLED device comprises an electron injecting/transporting layer comprising a benzoimidazole-containing compound, said layer further containing a reductive dopant selected from a group comprising a halide or an oxide of an alkali metal or of an alkaline earth metal or an organic complex of an alkali metal. The device may comprise a hole injection layer. The benzoimidazole-containing compound has both electron injecting and transporting properties.

The document WO 2007/018004 A1 discloses a nitrogenous heterocyclic derivative of specified structure, and an organic electroluminescence device comprising a negative electrode and a positive electrode and, interposed therebetween, one or two or more organic thin-film layers having at least a light emitting layer, wherein at least one of the organic thin-film layers contains the above nitrogenous heterocyclic derivative alone or as a component of mixture. Thus, there is provided an organic electroluminescence device capable of blue light emission realizing high emission brightness and luminescence efficiency, and provided a novel nitrogenous heterocyclic derivative for realizing of such inorganic electroluminescence device.

EP 0 949 696 A2 provides an organic EL device which is improved to produce an increased luminescence and have a prolonged lifetime. In an organic EL device comprising a cathode layer, an electron injection region, a light emission region and an anode layer as laminated in that order, the electron injection region contains an aromatic compound composed of carbon and hydrogen or an aromatic compound composed of carbon, hydrogen and oxygen, along with a reducing dopant, and the electron affinity of the electron injection region is controlled to fall between 1.8 and 3.6 eV, or the electron injection region contains an electron-transporting compound and a reducing dopant having a work function of at most 2.9 eV, and the electron affinity of the electron injection region is controlled to fall between 1.8 and 3.6 eV.

EP 1 722 604 A1 discloses an organic electroluminescence display comprising an electron injection layer, an electron transporting layer, an emitting layer, a hole transporting layer, and a hole injection layer between two electrodes. The electron transporting layer preferably comprises a metal complex of 8-hydroxyquinoline and may be doped with a reducing dopant such as an oxide of alkali metal.

In US 2003/0165715 A1 novel materials for electron injection/transportation and emitting layers can greatly improve the stability of an organic electroluminescence display are described. Electroluminescence displays incorporating these materials produce blue light at low voltages level. These novel organic materials include compounds in which one or two imidazole functional groups are introduced in the 2- or 2,6-site of 9,10 substituted anthracene. An organic electroluminescence display with an organic compound layer of these materials has high efficiency, thermal stability, operationally stability and maintains driving voltage before and after operation.

### [Disclosure]

### [Technical Problem]

The present inventors have found that in an organic light emitting device, when an electron injecting layer is not separately formed and a predetermined material is doped with an electron transporting material in the course of forming the electron transporting layer, performance of the device is improved while electron injecting and transporting characteristics of the device are not changed, and the production process of the device is simplified because the desired performance is obtained even if the electron injecting layer is not separately formed. Therefore, it is an object of the present invention to provide an organic light emitting device that does not affect electron injecting and transporting properties, has excellent performance, and is produced by using a simple process, and a method of producing the same.

### [Technical Solution]

In order to accomplish the above object, the present invention provides an organic light emitting device according to claim 1.

In addition, the present invention provides a method of producing an organic light emitting device according to claim 10.

Preferred embodiments are disclosed in the sub-claims.

### [Advantageous Effects]

An organic light emitting device according to the present invention includes an organic material layer in which an electron transporting material that is the compound as disclosed above is doped with metal halides. Accordingly, even if a separate electron injecting layer is not used, the electron injecting and transporting characteristics are excellent, thus, a production process is simple and economic efficiency is assured as compared to a known technology.

### [Description of Drawings]

FIG. 1 illustrates a current density according to DC bias voltage of an organic light emitting device of Example 1;
FIG. 2 illustrates a current efficiency according to the current density of the organic light emitting device of Example 1;
FIG. 3 illustrates a current density according to bias voltage of an organic light emitting device of Example 1; and
FIG. 4 illustrates a current density according to bias voltage in respects to each of four organic light emitting devices that are produced in Example 2.

### [Best Mode]

Hereinafter, the present invention will be described in detail.

In an organic light emitting device according to the present invention, among organic material layers that are disposed between two electrodes, at least one organic material layer comprises an electron transporting material doped with metal halides. The electron transporting material is the compound as disclosed above. In the present invention, in the course of forming a layer used to transport the electrons among the organic material layers, in the case of when the above electron transporting material is doped with metal halides the organic light emitting device characteristic is significantly improved while electron injecting and transporting characteristics are not affected. Therefore, even if the formation of the electron injecting layer, which is considered to be necessarily performed in order to efficiently operate the organic light emitting device in the related art, is not performed, the organic light emitting device is efficiently operated. In addition, the doping of the above-mentioned electron transporting material with the above doping material positively affects a life span of the device. Methods of doping the electron transporting material with known metal having a low work function to increase efficiency of the organic light emitting device without the electron injecting layer are known. However, the methods are known to be problematic in that it is difficult to use oxidizable metals having the low work function in practice due to a process difficulty and explosiveness.

In the present invention, the above electron transporting material is a material that can transmit the electrons injected from the cathode to the light emitting layer and has the high movability in respects to the electrons.

The compounds of Foumulae 5 to 11 are disclosed in Korean Patent Application Publication No. 2007-0118711, the disclosures of which are incorporated herein by reference in its entirety.

In the present invention, when the organic material layer is formed by using the above-mentioned electron transporting material, metal halides is doped as a doping material.

Examples of the above metal halides include LiF, MgF2, NaF, KF, or the like. In the present invention, among the doping materials are used, metal halides, and it is more preferable to use LiF.

In the present invention, it is preferable that metal halides be included in an amount in the range of 1 to 50% by weight based on the total weight of the materials of the organic material layer including the doping material.

The organic material layer that includes the electron transporting material and the doping material may be formed by using a method that is known in the art. For example, a deposition method and a solvent process, for example, spin coating, dip coating, doctor blading, screen printing, inkjet printing, or thermal transfer method, may be used.

The organic light emitting device according to the present invention may be produced by using a typical production method and material and may have a structure known in the art, except that at least one organic material layer is formed by using the electron transporting material and the doping material.

For example, the process of producing the organic light emitting device according to the present invention includes depositing metal, metal oxides having conductivity, or an alloy thereof on a substrate by using a PVD (physical vapor deposition) method such as sputtering or e-beam evaporation to form an anode, forming an organic material layer thereon, and forming a cathode thereon. In addition to the above-mentioned method, another method may be used. For example, the cathode, the organic material layer, and the anode may be sequentially deposited on the substrate to produce the organic light emitting device.

The organic material layer may have a multi layered structure that includes the hole injecting layer, the hole transporting layer, the light emitting layer, the electron transporting layer, the electron injecting layer and the like. However, the structure of the organic material layer is not limited thereto, and a portion of the layers may be removed or additional layer may be provided. In the present invention, unlike the known technology, the electron injecting layer may not be formed to simplify the production process of the organic light emitting device and to produce the organic light emitting device having the excellent performance. Accordingly, the organic light emitting device according to the present invention may not include the electron injecting layer. That is, the organic material layer, including the electron transporting material and the doping material, may be in contact with any one electrode. However, the case of when the electron injecting layer is included is not excluded from the scope of the present invention. Therefore, an electron injecting layer can be positioned between any one electrode and the organic material layer including the electron transporting material and the doping material.

The organic material layer may be produced by means of various types of polymer materials by using a deposition method as well as a solvent process such as spin coating, dip coating, doctor blading, screen printing, inkjet printing, heat transfer method or the like so that the organic material layer has a small number of layers.

It is preferable that the anode material have a large work function so that a hole is desirably injected into the organic material layer. Specific examples of the anode material that is capable of being used in the present invention include, but are not limited to metal such as vanadium, chrome, copper, zinc, gold, nickel, and platinum, or an alloy thereof; metal oxides such as zinc oxides, indium oxides, indium tin oxides (ITO), and indium zinc oxides (IZO); metal/oxide composites such as ZnO:Al or SnO₂:Sb; and conductive polymers such as poly(3-methylthiophene), poly[3,4-(ethylene-1,2- dioxy)thiophene] (PEDT), polypyrrole, and polyaniline. In addition, in the case of when hexanitrile hexaazatriperylene that is represented by the following Formula is used as the material of the hole injecting layer, aluminum (Al), silver (Ag), calcium (Ca) or the like may be used.

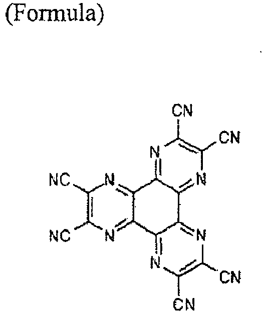

It is preferable that the cathode material have a small work function so that an electron is desirably injected into the organic material layer. Specific examples of the cathode material include, but are not limited to metal such as magnesium, calcium, sodium, potassium, titanium, indium, yttrium, lithium, gadolinium, aluminum, silver, tin, and lead, or an alloy thereof; and a multilayered material such as LiF/Al or LiO₂/Al.

The hole injecting material is a material that is capable of desirably receiving a hole from an anode at low voltage. It is preferable that the HOMO (highest occupied molecular orbital) level of the hole injecting material be located between the work function of the anode material and the HOMO level of its neighboring organic material layer. Specific examples of the hole injecting material include, but are not limited to organic materials of metal porphyrin, oligothiophene, and arylamine series, organic materials of hexanitrile hexaazatriphenylene and quinacridone series, organic materials of perylene series, and conductive polymers of on anthraquinone, polyaniline, and polythiophene series.

The hole transporting material is suitably a material having high hole mobility, which is capable of transferring holes from the anode or the hole injecting layer toward the light emitting layer. Specific examples of the hole transporting material include, but are not limited to organic materials of arylamine series, conductive polymers, and block copolymers having both conjugated portions and non-conjugated portions.

The light emitting material is a material capable of emitting visible light by accepting and recombining holes from the hole transporting layer and electrons from the electron transporting layer, and preferably a material having high quantum efficiency for fluorescence and phosphorescence. Specific examples of the light emitting material include, but are not limited to 8-hydroxyquinoline aluminum complex (Alq₃); compounds of carbazole series; dimerized styryl compounds; BAlq; 10-hydroxybenzoquinoline-metal compounds; compounds of benzoxazole, benzthiazole, and benzimidazole series; polymers of poly(p-phenylenevinylene) (PPV) series; spiro compounds; and compounds of polyfluorene and rubrene series.

In addition, the organic material layer may comprise an n-type organic material layer in contact with one electrode of the first electrode and the second electrode and a p-type organic material layer forming an NP junction together with the n-type organic material layer wherein energy levels of the layers satisfy the following Expressions (1) and (2): ${E}_{nL} - {E}_{F ⁢ 1} \leq 4 ⁢ eV$ ${E}_{pH} - {E}_{nL} \leq 1 ⁢ eV$ where E_{F1} is a Fermi energy level of the electrode , E_{nL} is an LUMO energy level of the n-type organic material layer, and E_{pH} is an HOMO energy level of the p-type organic material layer forming the NP junction together with the n-type organic material layer.

When the energy difference between the LUMO energy level of the n-type organic material layer and the Fermi energy level of the electrode is more than 4 eV, an effect of a surface dipole or a gap state on an energy barrier for hole injection or hole extraction is reduced. Also, when the energy difference between the LUMO energy level of the n-type organic material layer and the HOMO energy level of the p-type organic material layer is more than approximately 1 eV, the NP junction of the p-type organic material layer and the n-type organic material layer is not easily formed and thus a driving voltage for hole injection or hole extraction increases.

The compound represented by the following Formula 23 can be used as a material for the n-type organic material layer.

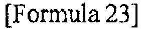

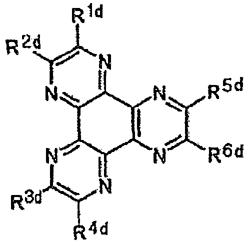

In Formula 23., each of R^{1d} to R^{6d} is selected from a group consisting of hydrogen, halogen atoms, nitrile (-CN), nitro (-N02), sulfonyl (-SO2R), sulfoxide (-SOR), sulfonamide (-SO2NR), sulfonate (-SO3R), trifluoromethyl (- CF3), ester (-COOR), amide (-CONHR or -CONRR<1>), substituted or unsubstituted straight or branched chain C1-C12 alkoxy, substituted or unsubstituted straight or branched C1-C12 alkyl , substituted or unsubstituted aromatic or non-aromatic heterocyclic rings, substituted or unsubstituted aryl , substituted or unsubstituted mono- or di-arylamine, and substituted or unsubstituted aralkylamine, and each of R and R' are selected from a group consisting of substituted or unsubstituted C₁-C₆₀ alkyl, substituted or unsubstituted aryl , and substituted or unsubstituted 5-7 membered heterocyclic rings.

Examples of the compound of Formula 23 may include compounds represented by the following Formulae 23-1 to 23-6.

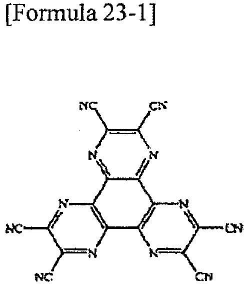

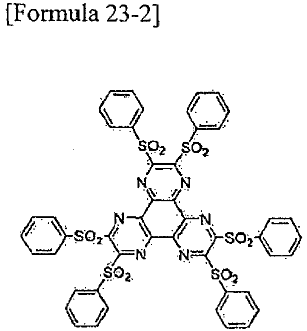

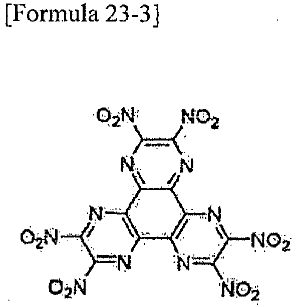

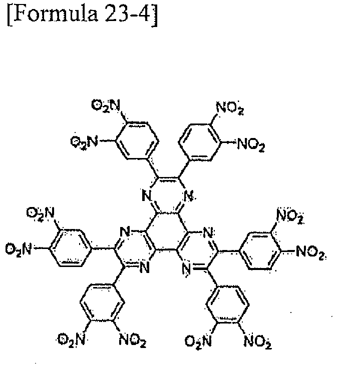

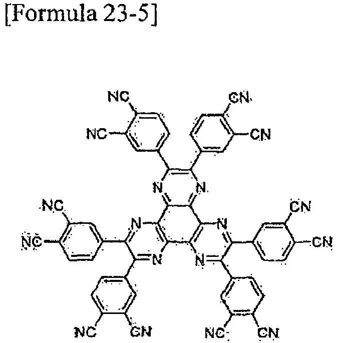

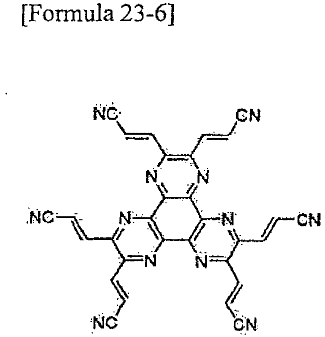

The n-type organic material layer may contain at least one compound selected from 2,3,5,6-tetrafluoro-7,7,8,8-tetracyanoquinodimethane (F4TCNQ), fluoro-substituted 3,4,9,10-perylenetetracarboxylic dianhydride (PTCDA), cyano-substituted 3,4,9,10-perylenetetracarboxylic dianhydride (PTCDA), naphthalene-tetracaboxyl ic-dianhydride (NTCDA), fluoro-substituted naphthalene-tetracaboxylic-dianhydride (NTCDA), or cyano-substituted naphthalene-tetracaboxyl ic-dianhydride (NTCDA).

The p-type organic material layer, forming an NP junction together with the n-type organic material layer, may be a hole injection layer, a hole transport layer, or emitting layer.

The organic light emitting device according to the present invention may be a top light emitting type, a bottom light emitting type, or a dual-sided light emitting type according to the type of material used. In addition, the organic light emitting device according to the present invention may have a negative structure in which the lower electrode is the cathode and the upper electrode is the anode or a positive structure in which the lower electrode is the anode and the upper electrode is the cathode.

### [Mode for Invention]

### EXAMPLE

### EXAMPLE 1

The electron transporting material of the following Formula was doped with LiF in an amount of 20% on the Al thin film having the thickness of 700 Å to form the layer having the thickness of 200 Å. Subsequently, Alq₃ (aluminum tris(8-hydroxyquinoline)) of the following Formula was deposited under a vacuum to form the light emitting layer having the thickness of 300 A, and NPB of the following Formula was deposited thereon under a vacuum to form the hole transporting layer having the thickness of 400 Å. Subsequently, the HAT material of the following Formula was deposited thereon by heating under a vacuum to form the hole injecting layer having the thickness of 500 Å. The IZO layer was formed thereon to have a thickness of 1750 Å.

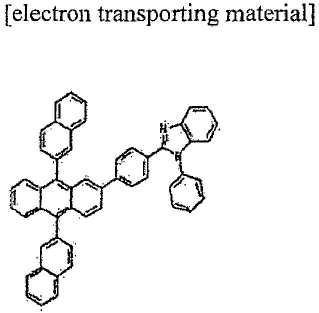

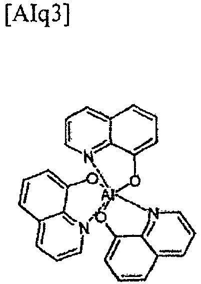

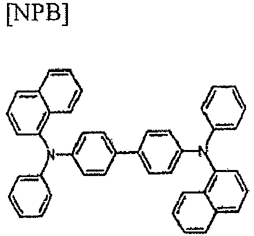

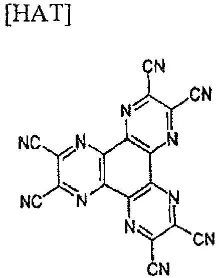

In this connection, the deposition rate of the organic material was maintained at 0.4 to 1.0 Å/sec, and the degree of vacuum was maintained at 2 x 10⁻⁷ to 2 x 10⁻⁸ torr during the deposit ion.

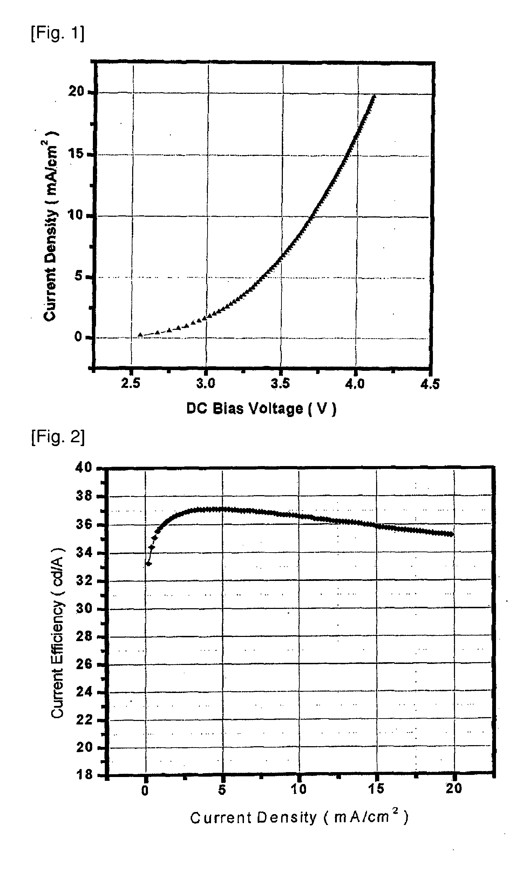

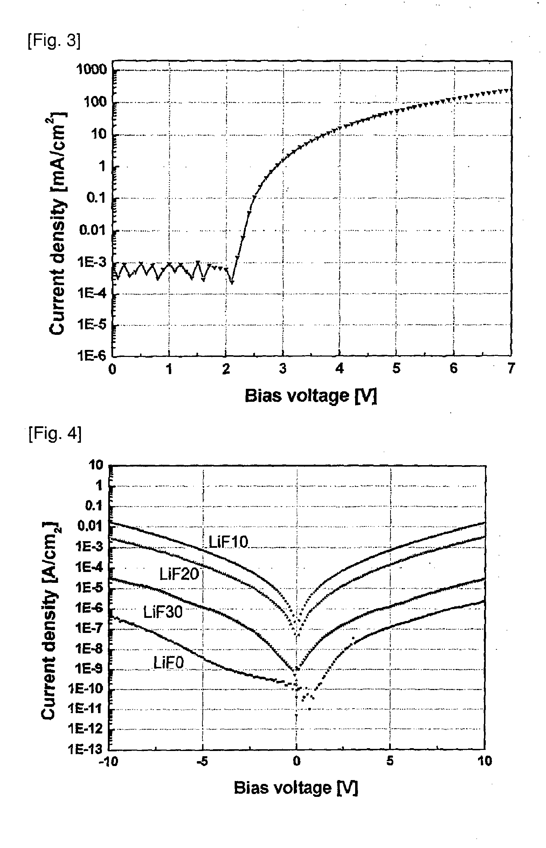

Voltage was applied on the organic light emitting device that was produced in Example 1 at the interval of 0.2 mA/cm² to measure the voltage, the luminance, and the leakage current. The results are shown in FIGS. 1, 2, and 3. FIGS. 1, 2, and 3 are graphs that illustrate the current-voltage characteristic and the light emission characteristic of the organic light emitting device. In the above-mentioned graphs, when the electron transporting material was doped with LiF in an amount of 20%, if the electrons were not injected and transported, the normal rectifying property and light emission property were not obtained, but the voltage was high and the light emission property was reduced. However, as shown in FIGS. 1 and 2, the voltage was 3.6 V at 5 mA/cm², the luminance was 37.5 cd/A, and the leakage current characteristic shown in FIG. 3 was stable. Thus, the intrinsic device characteristics of the organic light emitting device were obtained.

### EXAMPLE 2

The electron transporting material of Example 1 was dopoed with LiF in an amount of 0%, 10%, 20%, and 30% on the Al thin film having the thickness of 700 Å to form the layer having the thickness of 1500 Å. Subsequently, Al having the thickness of 700 Å was deposited thereon. In respects to the four produced organic light emitting devices, the current density was measured according to bias voltage, and the results are shown in FIG.4.

FIG. 4 illustrates reverse direction and forward direction current- voltage characteristics of the organic light emitting devices produced in Example 2. In the case of when the electron transporting material was doped with LiF in an amount of 0%, it was difficult to inject the electrons. In the case of when the electron transporting material was doped with LiF in an amount of 10%, 20%, and 30%, the electron injection characteristic was significantly increased.

## Claims

1. An organic light emitting device comprising:
a first electrode;
a second electrode; and
at least one organic material layer that includes a light emitting layer disposed between the electrodes,
wherein at least one layer of the organic material layer includes an electron transporting material doped with metal halides, and the electron transporting material is the compound having the functional group selected from the group consisting of an imidazole group, an oxazole group, and a thiazole group; the compound having a quinoline group; or the compound having one of following chemical formulae, 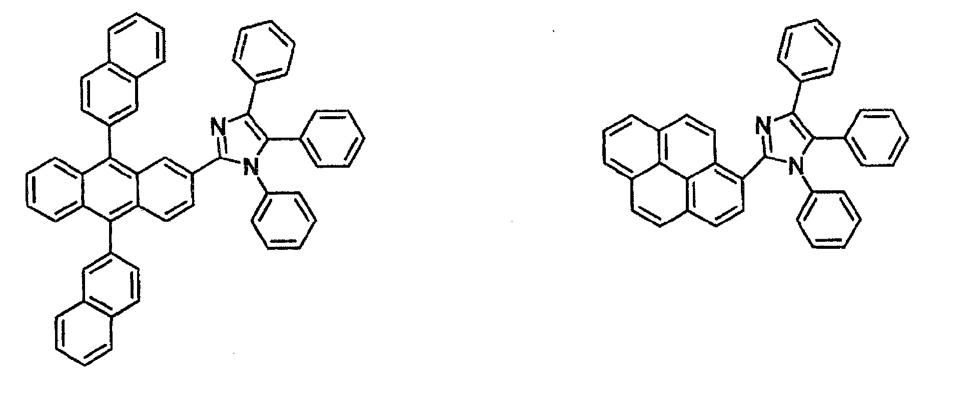 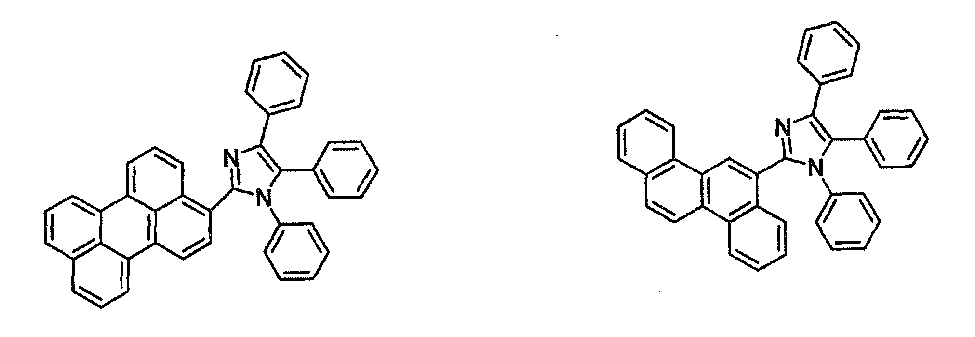
and wherein the compound having the functional group that is selected from the group consisting of the imidazole group, the oxazole group, and the thiazole group is a compound of the following Formula 3, and the compound having the quinoline group is selected from compounds of the following Formulae 5 to 11: 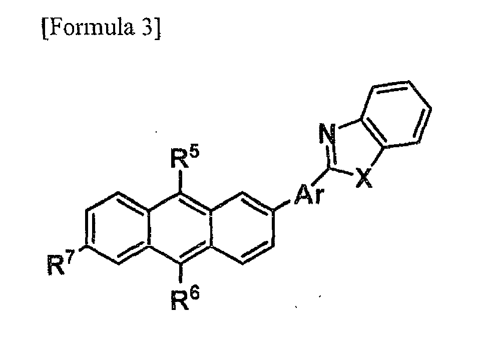
wherein R⁵ to R⁷ are the same or different from each other, are each independently a hydrogen atom, a C₁ to C₂₀ aliphatic hydrocarbon, an aromatic ring, an aromatic hetero ring or an aliphatic or aromatic fused ring; Ar is a direct bond, an aromatic ring, an aromatic hetero ring, or an aliphatic or aromatic fused ring; and X is O, S, or NRₐ, Rₐ is a hydrogen atom, a C₁ to C₇ aliphatic hydrocarbon, an aromatic ring, or an aromatic hetero ring, with a proviso that R₅ and R₆ can not simultaneously be hydrogen, 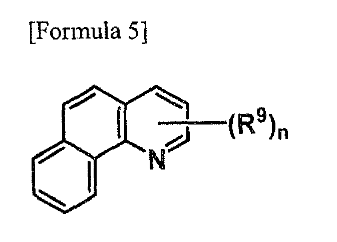 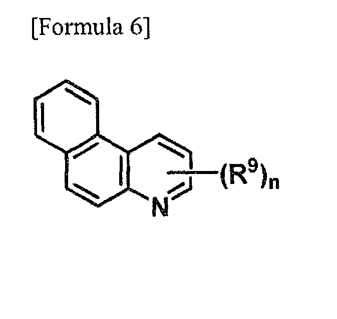 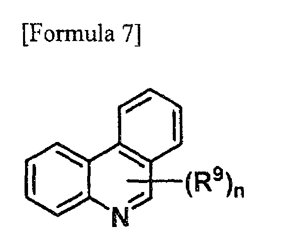 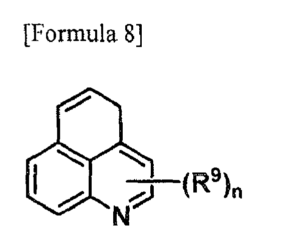 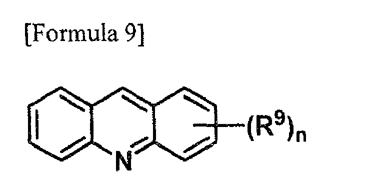 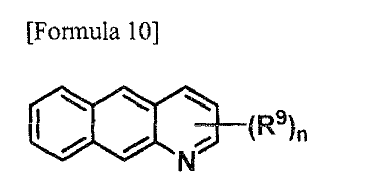 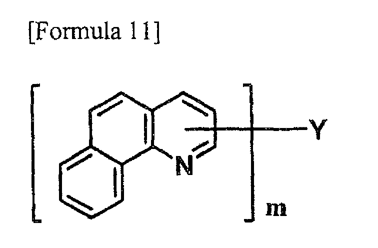
wherein n is an integer in the range of 0 to 9, m is an integer in the range of 2 or more, R⁹ is one selected from the group consisting of hydrogen, an alkyl group, a cycloalkyl group, an aralkyl group, an alkenyl group, a cycloalkenyl group, an alkoxy group, an alkylthio group, an arylether group, an arylthioether group, an aryl group, a heterocyclic group, halogen, a cyano group, an aldehyde group, a carbonyl group, a carboxyl group, an ester group, a carbamoyl group, an amino group, a nitro group, a silyl group, a siloxanyl group, and a ring structure that is formed in conjunction with an adjacent group; the above substituent groups may be unsubstituted or substituted, and the above substitutent groups are the same or different from each other when n is 2 or more, and
Y is a group having 2 or more valence of the above-mentioned R⁹ groups.

2. The organic light emitting device according to claim 1, wherein the organic material layer further includes a hole injecting layer, a hole transporting layer, or a hole injecting and transporting layer.

3. The organic light emitting device according to claim 1, wherein the organic material layer, including an electron transporting material doped with metal halides is in contact with any one of the first electrode and the second electrode.

4. The organic light emitting device according to claim 1, wherein the compound having the functional group that is selected from the group consisting of the imidazole group, the oxazole group, and the thiazole group is selected from compounds of the following Formulae:

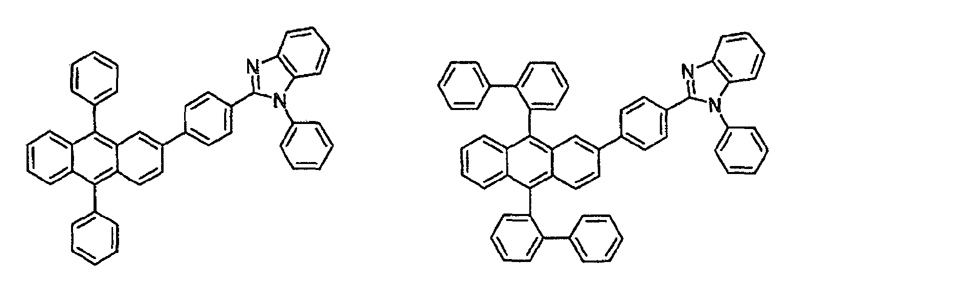

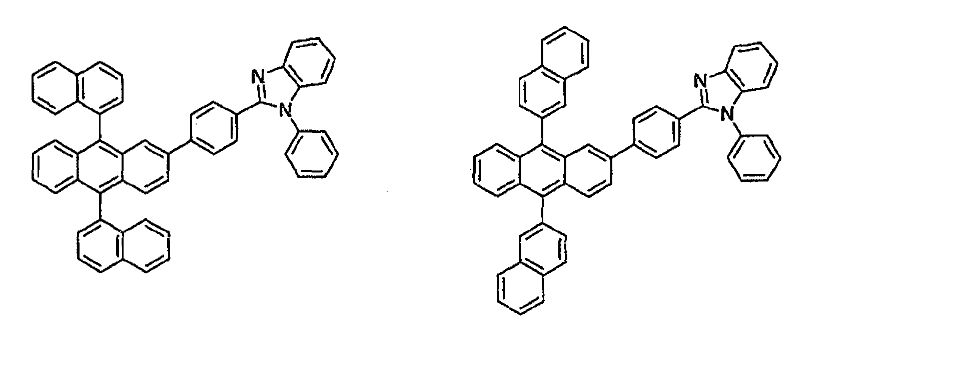

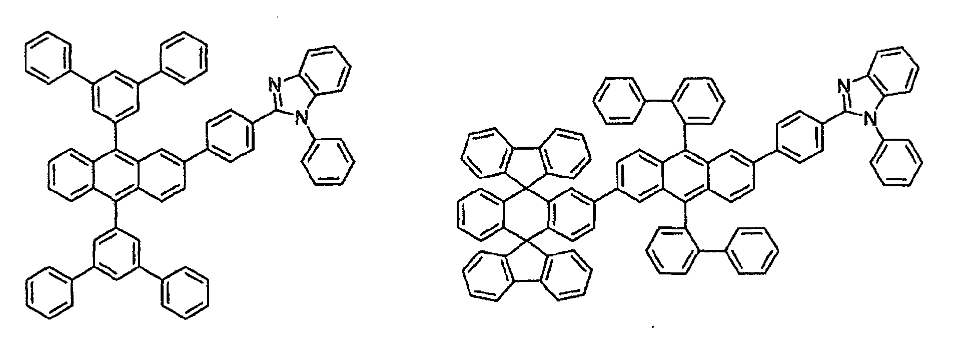

5. The organic light emitting device according to claim 1, wherein the metal halides are selected from LiF, MgF₂, NaF, and KF.

6. The organic light emitting device according to claim 1, wherein the electron transporting material is a compound of the following Formula, and metal halides is LiF:

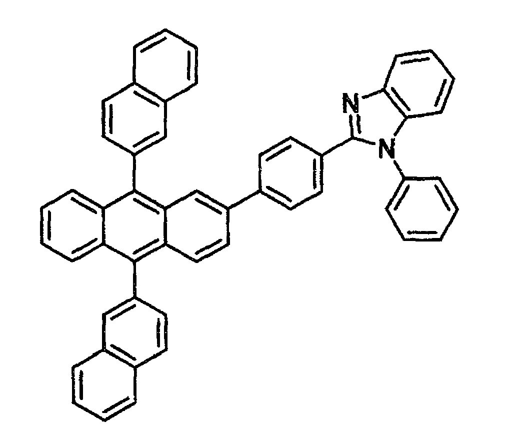

7. The organic light emitting device according to claim 1, wherein metal halides is included in an amount in the range of 1 to 50% by weight based on a total weight of a material of the organic material layer including metal halides.

8. The organic light emitting device according to claim 1, wherein an electron injecting layer is positioned between any one of the first electrode and the second electrode and the organic material layer, including an electron transporting material doped with metal halides.

9. The organic light emitting device according to claim 1, wherein the organic material layer comprises an n-type organic material layer in contact with one electrode of the first electrode and the second electrode and a p-type organic material layer that forms an NP junction together with the n-type organic material layer, and energy levels of the layers satisfy the following Expressions (1) and (2): ${E}_{nL} - {E}_{F ⁢ 1} ≦ 4 ⁢ eV$ ${E}_{pH} - {E}_{nL} ≦ 1 eV$
Wherein E_{F1} is a Fermi energy level of the electrode, E_{nL} is an LUMO energy level of the n-type organic material layer, and E_{pH} is an HOMO energy level of the p-type organic material layer forming the NP junction together with the n-type organic material layer.

10. A method of producing an organic light emitting device, comprising:
forming a first electrode;
forming at least one organic material layer including a light emitting layer on the first electrode; and forming a second electrode on the organic substance layer,
wherein at least one layer of the organic material layer includes an electron transporting material doped with metal halides, and the electron transporting material is the compound having the functional group selected from the group consisting of an imidazole group, an oxazole group, and a thiazole group; the compound having a quinoline group; or the compound having one of following chemical formulae, 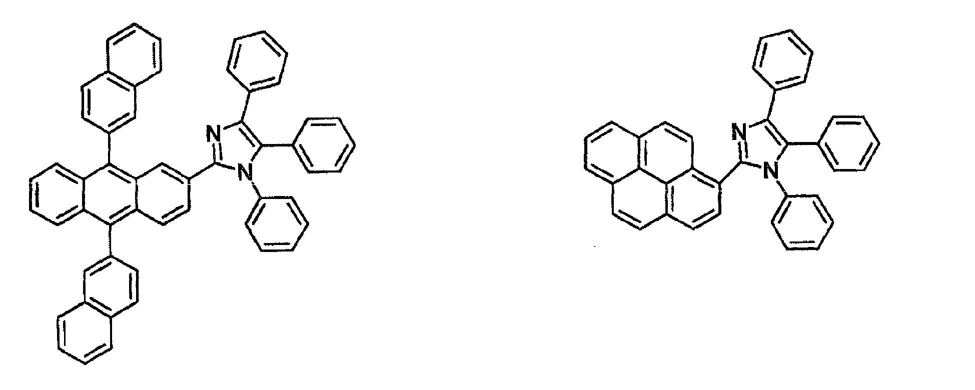 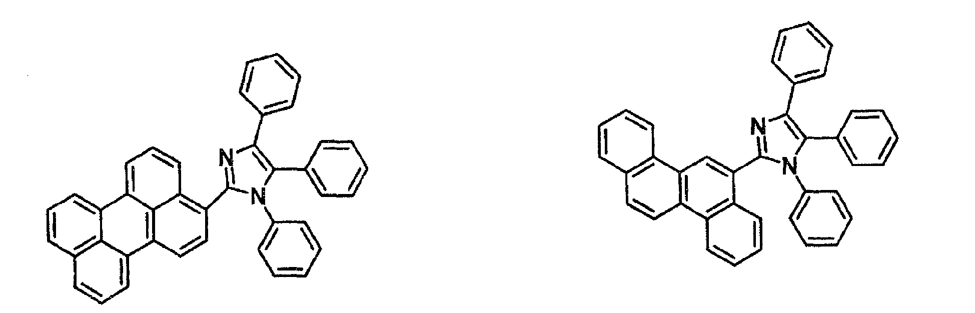
and wherein the compound having the functional group that is selected from the group consisting of the imidazole group, the oxazole group, and the thiazole group is a compound of the following Formula 3, and the compound having the quinolone group is selected from compounds of the following Formulae 5 to 11: 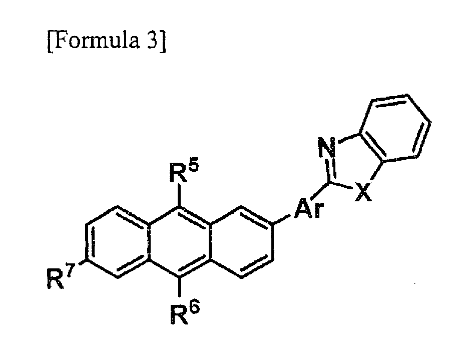
wherein R⁵ to R⁷ are the same or different from each other, are each independently a hydrogen atom, a C₁ to C₂₀ aliphatic hydrocarbon, an aromatic ring, an aromatic hetero ring or an aliphatic or aromatic fused ring; Ar is a direct bond, an aromatic ring, an aromatic hetero ring, or an aliphatic or aromatic fused ring; and X is O, S, or NRₐ, Rₐ is a hydrogen atom, a C₁ to C₇ aliphatic hydrocarbon, an aromatic ring, or an aromatic hetero ring, with a proviso that R₅ and R₆ can not simultaneously be hydrogen, 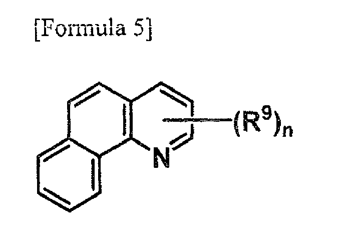 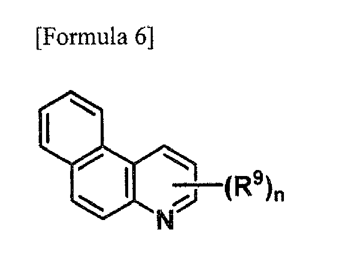 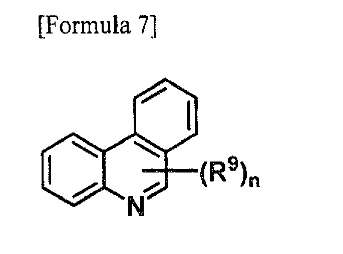 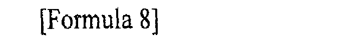 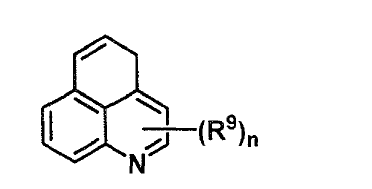 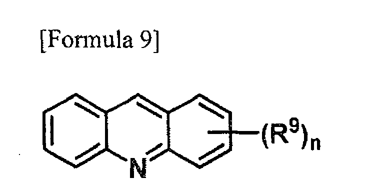 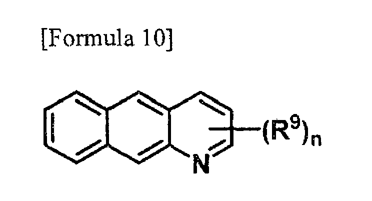 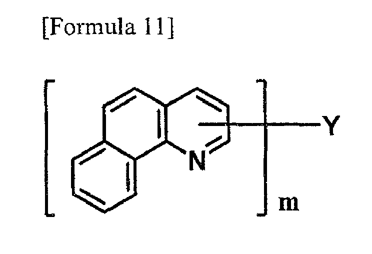
wherein n is an integer in the range of 0 to 9, m is an integer in the range of 2 or more, R⁹ is one selected from the group consisting of hydrogen, an alkyl group, a cycloalkyl group, an aralkyl group, an alkenyl group, a cycloalkenyl group, an alkoxy group, an alkylthio group, an arylether group, an arylthioether group, an aryl group, a heterocyclic group, halogen, a cyano group, an aldehyde group, a carbonyl group, a carboxyl group, an ester group, a carbamoyl group, an amino group, a nitro group, a silyl group, a siloxanyl group, and a ring structure that is formed in conjunction with an adjacent group; the above substituent groups may be unsubstituted or substituted, and the above substitutent groups are the same or different from each other when n is 2 or more, and
Y is a group having 2 or more valence of the above-mentioned R⁹ groups.

## Patentansprüche

1. Organisches lichtemittierendes Bauelement, welches umfasst:
eine erste Elektrode;
eine zweite Elektrode; und
wenigstens eine organische Materialschicht, die eine lichtemittierende Schicht, angeordnet zwischen den Elektroden, einschließt,
wobei wenigstens eine Schicht der organischen Materialschicht ein Elektronentransportmaterial dotiert mit Metallhalogeniden einschließt, und wobei das Elektronentransportmaterial die Verbindung mit der funktionellen Gruppe, die ausgewählt ist aus der Gruppe bestehend aus einer Imidazolgruppe, einer Oxazolgruppe und einer Thiazolgruppe; die Verbindung, die eine Chinolingruppe aufweist; oder die Verbindung, die eine der folgenden chemischen Formeln aufweist, ist 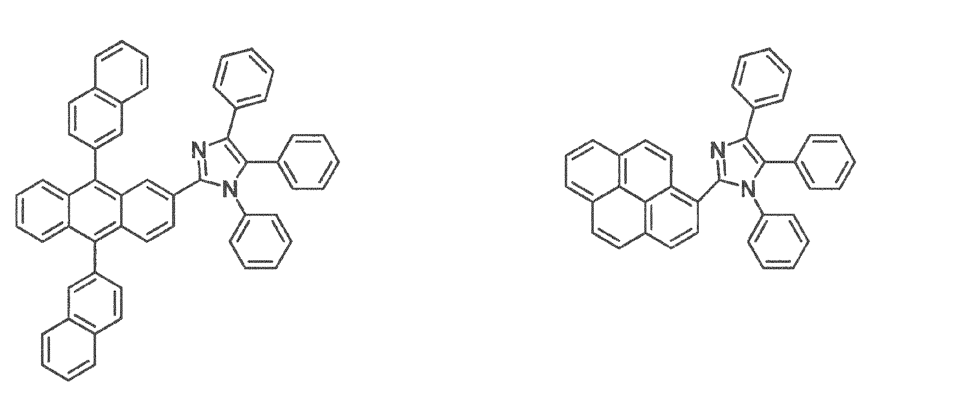 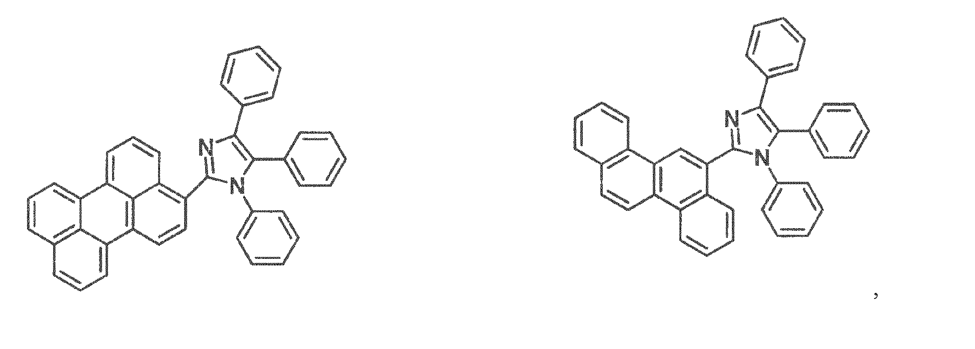
und wobei die Verbindung mit der funktionellen Gruppe, die ausgewählt ist aus der Gruppe bestehend aus der Imidazolgruppe, der Oxazolgruppe und der Thiazolgruppe, eine Verbindung der folgenden Formel 3 ist, und wobei die Verbindung mit der Chinolingruppe ausgewählt ist aus Verbindungen der folgenden Formeln 5 bis 11: 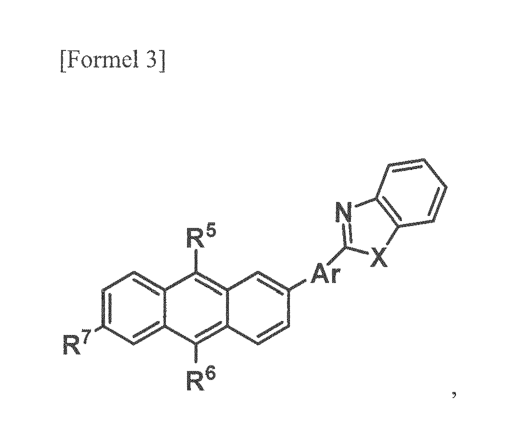
wobei R⁵ bis R⁷ gleich oder unterschiedlich voneinander sind und jeweils unabhängig ein Wasserstoffatom, ein aliphatischer C₁- bis C₂₀-Kohlenwasserstoff, ein aromatischer Ring, ein aromatischer Heteroring oder ein aliphatischer oder aromatischer kondensierter Ring sind; Ar eine direkte Bindung, ein aromatischer Ring, ein aromatischer Heteroring oder ein aliphatischer oder aromatischer kondensierter Ring ist; und X O, S oder NRₐ ist, wobei Rₐ ein Wasserstoffatom, ein aliphatischer C₁- bis C₇-Kohlenwasserstoff, ein aromatischer Ring oder ein aromatischer Heteroring ist, mit der Maßgabe, dass R⁵ und R⁶ nicht gleichzeitig Wasserstoff sind, 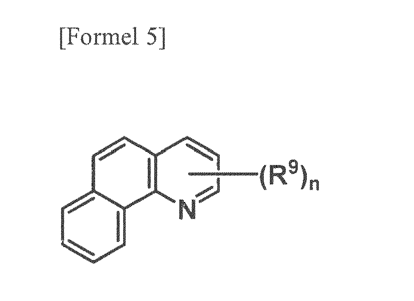 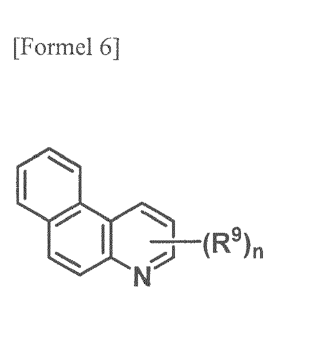 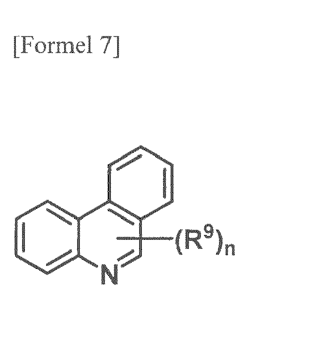 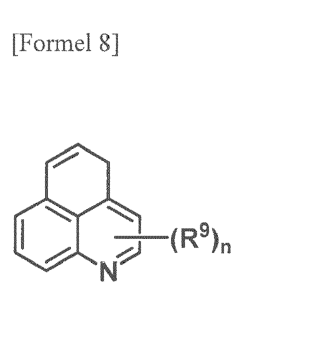 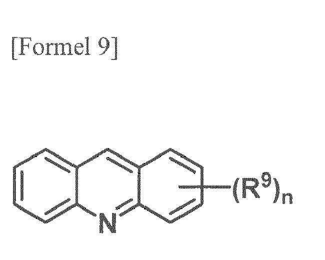 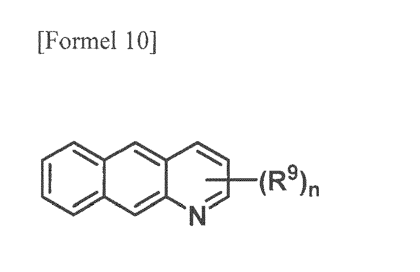 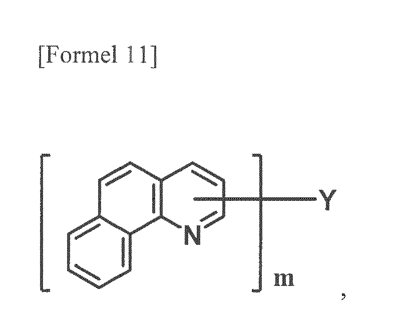
wobei n eine ganze Zahl im Bereich von 0 bis 9 ist, m eine ganze Zahl in dem Bereich von 2 oder höher ist, R⁹ einer ist ausgewählt aus der Gruppe bestehend aus Wasserstoff, einer Alkylgruppe, einer Cycloalkylgruppe, einer Aralkylgruppe, einer Alkenylgruppe, einer Cycloalkenylgruppe, einer Alkoxygruppe, einer Alkylthiogruppe, einer Arylethergruppe, einer Arylthioethergruppe, einer Arylgruppe, einer heterozyklischen Gruppe, Halogen, einer Cyanogruppe, einer Aldehydgruppe, einer Carbonylgruppe, einer Carboxylgruppe, einer Estergruppe, einer Carbamoylgruppe, einer Aminogruppe, einer Nitrogruppe, einer Silylgruppe, einer Siloxanylgruppe und einer Ringstruktur ist, die gebildet ist in Verbindung mit einer benachbarten Gruppe; wobei die obigen Substituentengruppen unsubstituiert oder substituiert sein können, und wobei die obigen Substituentengruppen gleich oder unterschiedlich voneinander sind, wenn n 2 oder höher ist; und
Y eine Gruppe mit 2 oder mehr Valenzen der oben erwähnten R⁹-Gruppen ist.

2. Organisches lichtemittierendes Bauelement nach Anspruch 1, wobei die organische Materialschicht ferner eine Lochinjektionsschicht, eine Lochtransportschicht oder eine Lochinjektions- und Transportschicht einschließt.

3. Organisches lichtemittierendes Bauelement nach Anspruch 1, wobei die organische Materialschicht, einschließend ein Elektronentransportmaterial dotiert mit Metallhalogeniden, in Kontakt mit irgendeiner der ersten Elektrode und der zweiten Elektrode ist.

4. Organisches lichtemittierendes Bauelement nach Anspruch 1, wobei die Verbindung mit der funktionellen Gruppe, die ausgewählt ist aus der Gruppe bestehend aus der Imidazolgruppe, der Oxazolgruppe und der Thiazolgruppe, ausgewählt ist aus Verbindungen der folgenden Formeln:

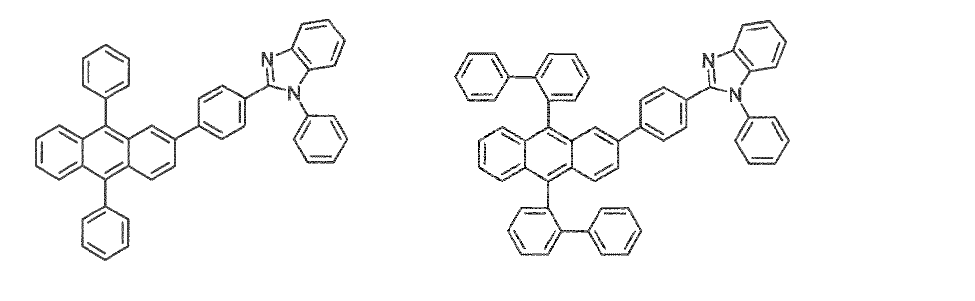

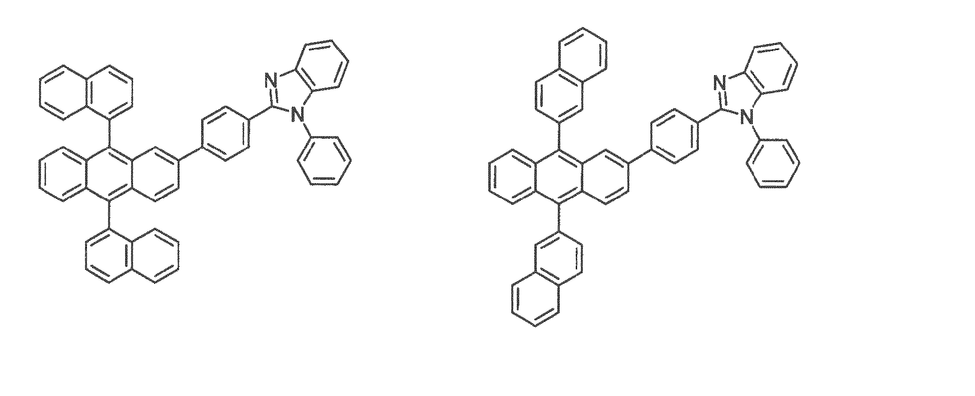

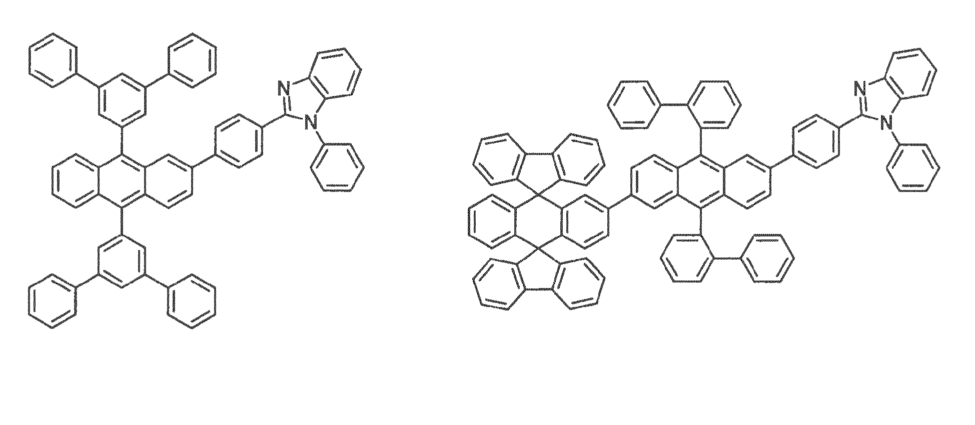

5. Organisches lichtemittierendes Bauelement nach Anspruch 1, wobei die Metallhalogenide ausgewählt sind aus LiF, MgF₂, NaF und KF.

6. Organisches lichtemittierendes Bauelement nach Anspruch 1, wobei das Elektronentransportmaterial eine Verbindung der folgenden Formel ist und Metallhalogenid LiF ist:

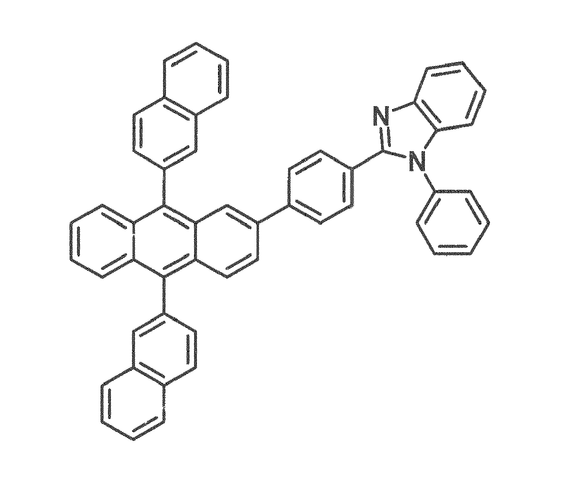

7. Organisches lichtemittierendes Bauelement nach Anspruch 1, wobei Metallhalogenid in einer Menge in dem Bereich von 1 bis 50 Gew.-%, basierend auf einem Gesamtgewicht eines Materials der organischen Materialschicht einschließend Metallhalogenide, ist.

8. Organisches lichtemittierendes Bauelement nach Anspruch 1, wobei eine Elektroneninjektionsschicht zwischen irgendeiner der ersten Elektrode und der zweiten Elektrode und der organischen Materialschicht, einschließend ein Elektronentransportmaterial dotiert mit Metallhalogeniden, positioniert ist.

9. Organisches lichtemittierendes Bauelement nach Anspruch 1, wobei die organische Materialschicht eine n-artige organische Materialschicht in Kontakt mit einer Elektrode der ersten Elektrode und der zweiten Elektrode und eine p-artige organische Materialschicht, die eine NP-Junktion zusammen mit der n-artigen organischen Materialschicht bildet, umfasst, und wobei Energieniveaus der Schichten die folgenden Ausdrücke (1) und (2) erfüllen: ${E}_{nL} - {E}_{F ⁢ 1} ≦ 4 eV$ ${E}_{pH} - {E}_{nL} ≦ 1 eV$
wobei E_{F1} ein Fermi-Energieniveau der Elektrode ist, E_{nL} ein LUMO-Energieniveau der n-artigen organischen Materialschicht ist und E_{pH} ein HOMO-Energieniveau der p-artigen organischen Materialschicht ausbildend die NP-Junktion zusammen mit der n-artigen organischen Materialschicht ist.

10. Verfahren zum Herstellen eines organischen lichtemittierenden Bauelements, welches umfasst:
Bilden einer ersten Elektrode;
Bilden wenigstens einer organischen Materialschicht einschließend eine lichtemittierende Schicht auf der ersten Elektrode; und
Bilden einer zweiten Elektrode auf der organischen Materialschicht,
wobei wenigstens eine Schicht der organischen Materialschicht ein Elektronentransportmaterial dotiert mit Metallhalogeniden einschließt, und wobei das Elektronentransportmaterial die Verbindung mit der funktionellen Gruppe, die ausgewählt ist aus der Gruppe bestehend aus einer Imidazolgruppe, einer Oxazolgruppe und einer Thiazolgruppe; die Verbindung, die eine Chinolingruppe aufweist; oder die Verbindung, die eine der folgenden chemischen Formeln aufweist, ist 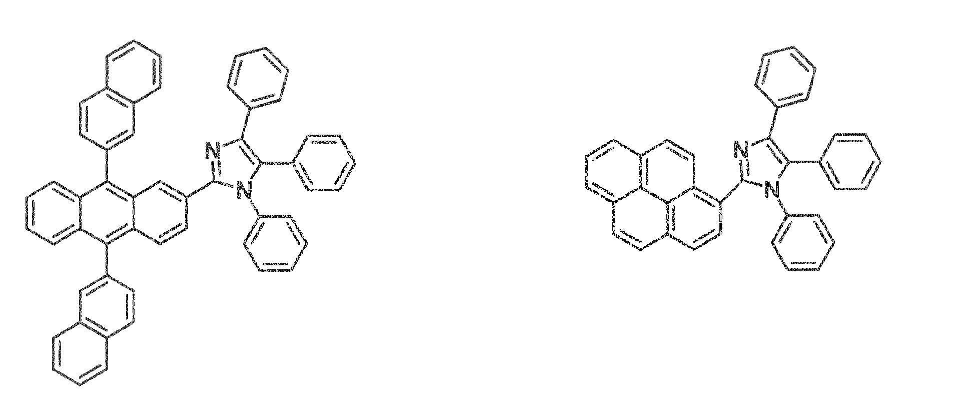 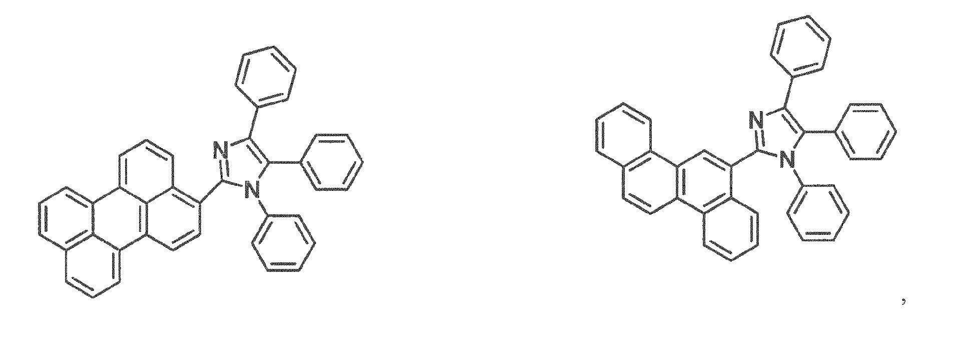
und wobei die Verbindung mit der funktionellen Gruppe, die ausgewählt ist aus der Gruppe bestehend aus der Imidazolgruppe, der Oxazolgruppe und der Thiazolgruppe, eine Verbindung der folgenden Formel 3 ist, und wobei die Verbindung mit der Chinolingruppe ausgewählt ist aus Verbindungen der folgenden Formeln 5 bis 11: 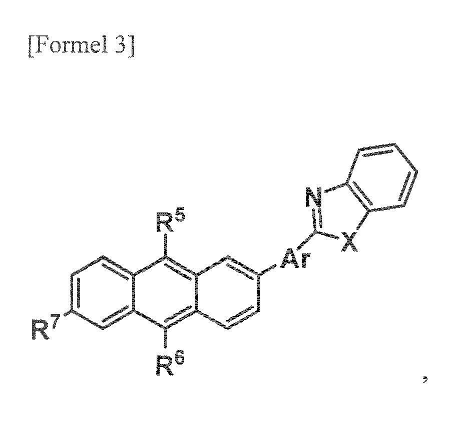
wobei R⁵ bis R⁷ gleich oder unterschiedlich voneinander sind und jeweils unabhängig ein Wasserstoffatom, ein aliphatischer C₁- bis C₂₀-Kohlenwasserstoff, ein aromatischer Ring, ein aromatischer Heteroring oder ein aliphatischer oder aromatischer kondensierter Ring sind; Ar eine direkte Bindung, ein aromatischer Ring, ein aromatischer Heteroring oder ein aliphatischer oder aromatischer kondensierter Ring ist; und X O, S oder NRₐ ist, wobei Rₐ ein Wasserstoffatom, ein aliphatischer C₁- bis C₇-Kohlenwasserstoff, ein aromatischer Ring oder ein aromatischer Heteroring ist, mit einer Maßgabe, dass R⁵ und R⁶ nicht gleichzeitig Wasserstoff sind 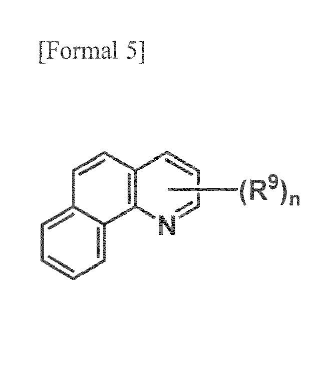 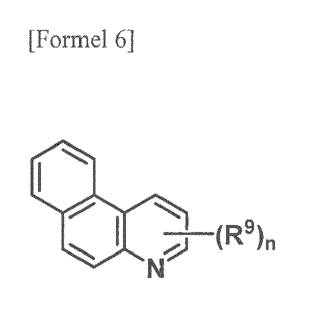 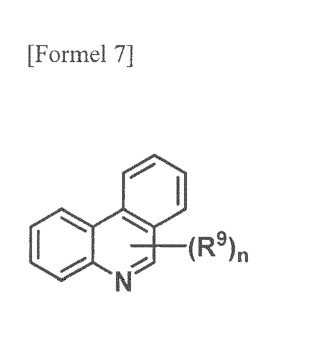 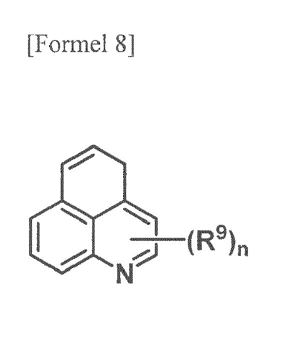 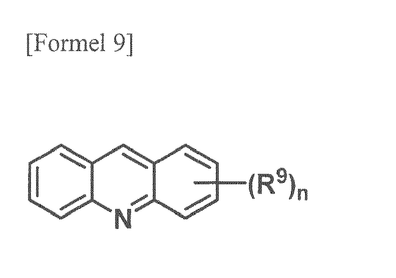 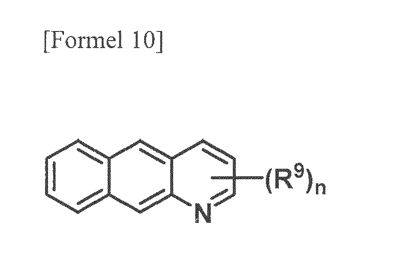 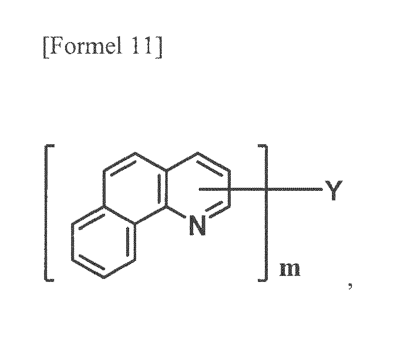
wobei n eine ganze Zahl in dem Bereich von 0 bis 9 ist, m eine ganze Zahl in dem Bereich von 2 oder höher ist, R⁹ einer ist ausgewählt aus der Gruppe bestehend aus Wasserstoff, einer Alkylgruppe, einer Cycloalkylgruppe, einer Aralkylgruppe, einer Alkenylgruppe, einer Cycloalkenylgruppe, einer Alkoxygruppe, einer Alkylthiogruppe, einer Arylethergruppe, einer Arylthioethergruppe, einer Arylgruppe, einer heterozyklischen Gruppe, Halogen, einer Cyanogruppe, einer Aldehydgruppe, einer Carbonylgruppe, einer Carboxylgruppe, einer Estergruppe, einer Carbamoylgruppe, einer Aminogruppe, einer Nitrogruppe, einer Silylgruppe, einer Siloxanylgruppe und einer Ringstruktur ist, die gebildet ist in Verbindung mit einer benachbarten Gruppe; wobei die obigen Substituentengruppen unsubstituiert oder substituiert sein können, und wobei die obigen Substituentengruppen gleich oder unterschiedlich voneinander sind, wenn n 2 oder höher ist; und
Y eine Gruppe mit 2 oder mehr Valenzen der oben erwähnten R⁹-Gruppen ist.

## Revendications

1. Dispositif organique électroluminescent comprenant :
une première électrode ;
une deuxième électrode ; et
au moins une couche de matériau organique qui comprend une couche électroluminescente disposée entre les électrodes,
dans lequel au moins une couche de la couche de matériau organique comprend un matériau de transport d'électrons dopé avec des halogénures de métaux et le matériau de transport d'électrons est le composé comprenant le groupe fonctionnel sélectionné parmi le groupe constitué d'un groupe imidazole, d'un groupe oxazole et d'un groupe thiazole ; le composé comprenant un groupe quinoline ; ou le composé comprenant l'une des formules chimiques suivantes, 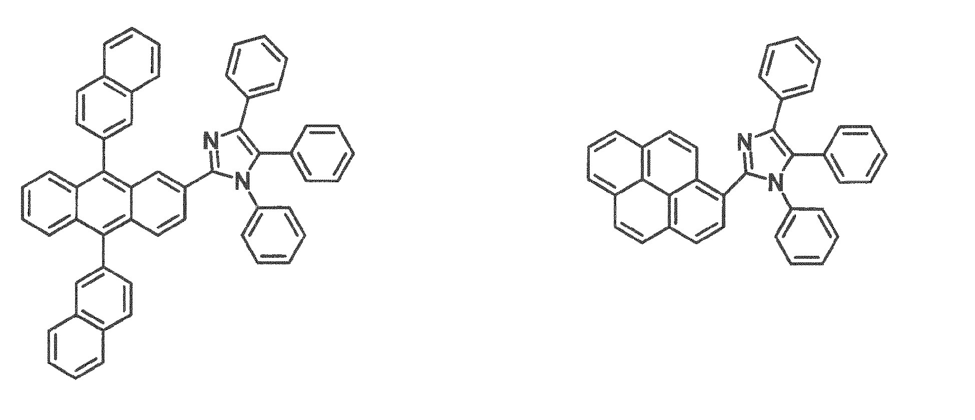 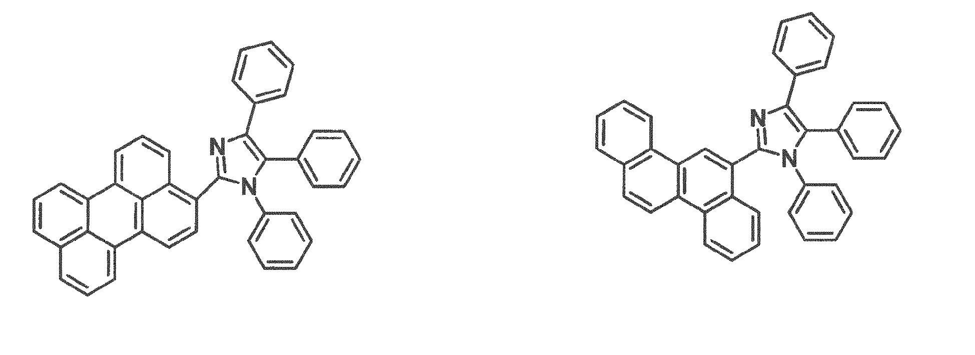
et dans lesquelles formules le composé comprenant le groupe fonctionnel qui est sélectionné parmi le groupe constitué du groupe imidazole, du groupe oxazole et du groupe thiazole est un composé de la Formule 3 suivante et le composé comprenant le groupe quinoline est sélectionné parmi les composés des Formules 5 à 11 suivantes : 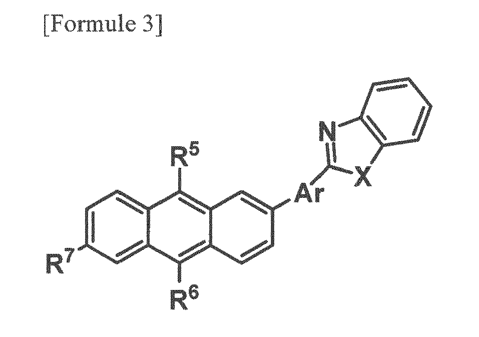
dans laquelle R⁵ à R⁷ sont identiques ou différents l'un de l'autre, représentent chacun indépendamment un atome d'hydrogène, un hydrocarbure aliphatique en C₁ à C₂₀, un cycle aromatique, un hétérocycle aromatique ou un cycle aliphatique ou aromatique condensé ; Ar représente une liaison directe, un cycle aromatique, un hétérocycle aromatique ou un cycle aliphatique ou aromatique condensé ; et X représente O, S ou NRₐ, Rₐ représente un atome d'hydrogène, un hydrocarbure aliphatique en C₁ à C₇, un cycle aromatique ou un hétérocycle aromatique, à la condition que R₅ et R₆ ne peuvent pas représenter simultanément un hydrogène, 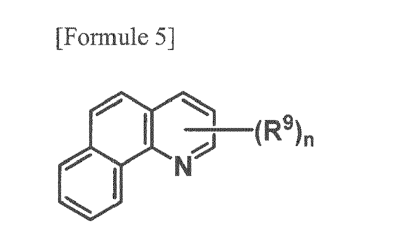 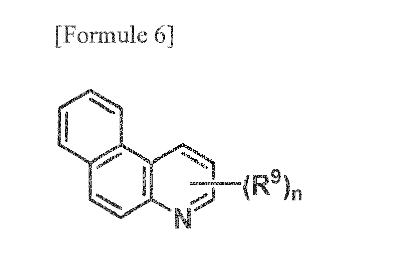 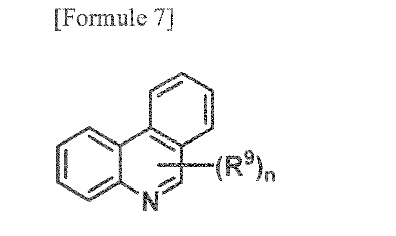 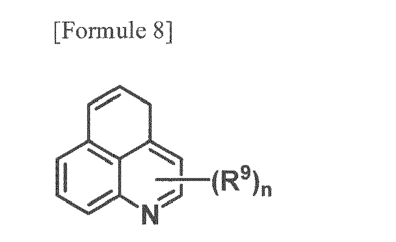 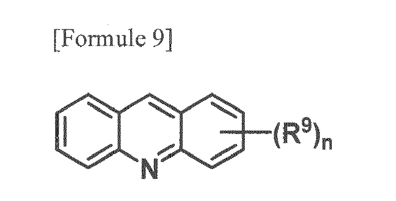 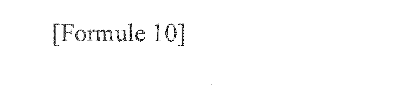 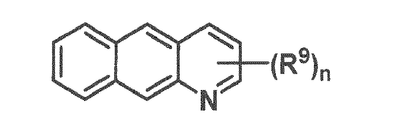 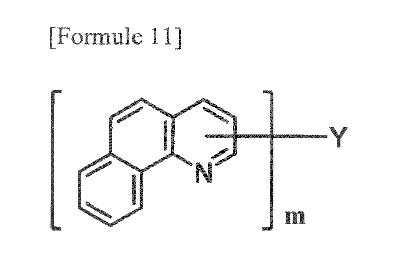
dans lesquelles formules n est un entier compris entre 0 et 9, m est un entier compris dans la plage de 2 ou plus, R⁹ représente un composé sélectionné parmi le groupe constitué d'un hydrogène, d'un groupe alkyle, d'un groupe cycloalkyle, d'un groupe aralkyle, d'un groupe alkényle, d'un groupe cycloalkényle, d'un groupe alcoxy, d'un groupe alkylthio, d'un groupe aryléther, d'un groupe arylthioéther, d'un groupe aryle, d'un groupe hétérocyclique, d'un halogène, d'un groupe cyano, d'un groupe aldéhyde, d'un groupe carbonyle, d'un groupe carboxyle, d'un groupe ester, d'un groupe carbamoyle, d'un groupe amino, d'un groupe nitro, d'un groupe silyle, d'un groupe siloxanyle et d'une structure cyclique qui est formée en conjonction avec un groupe adjacent ; les groupes des substituants susmentionnés peuvent être non substitués ou substitués et les groupes de substituants susmentionnés sont identiques ou différents les uns des autres lorsque n vaut 2 ou plus, et
Y représente un groupe ayant une valence égale à 2 ou plus des groupes R⁹ susmentionnés.

2. Dispositif organique électroluminescent selon la revendication 1, dans lequel la couche de matériau organique comprend en outre une couche pour injection de trous, une couche pour transport de trous ou une couche pour injection et transport de trous.

3. Dispositif organique électroluminescent selon la revendication 1, dans lequel la couche de matériau organique, y compris le matériau de transport d'électrons dopé par des halogénures de métaux, est en contact avec l'une quelconque de la première électrode et de la deuxième électrode.

4. Dispositif organique électroluminescent selon la revendication 1, dans lequel le composé comprenant le groupe fonctionnel est sélectionné parmi le groupe constitué du groupe imidazole, du groupe oxazole et le groupe thiazole est sélectionné parmi les composés des formules suivantes :

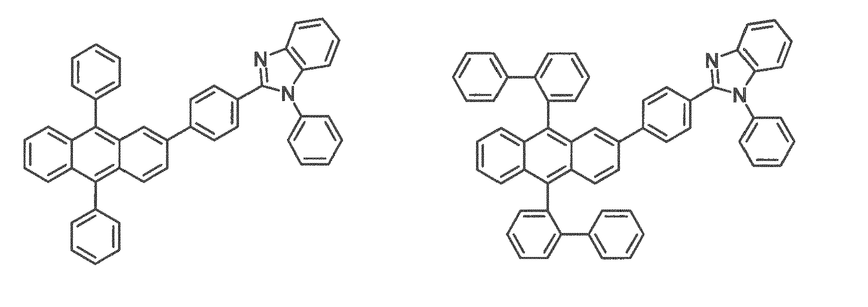

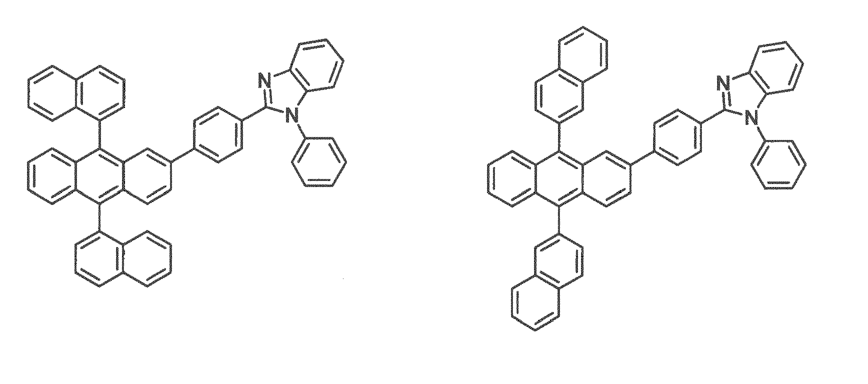

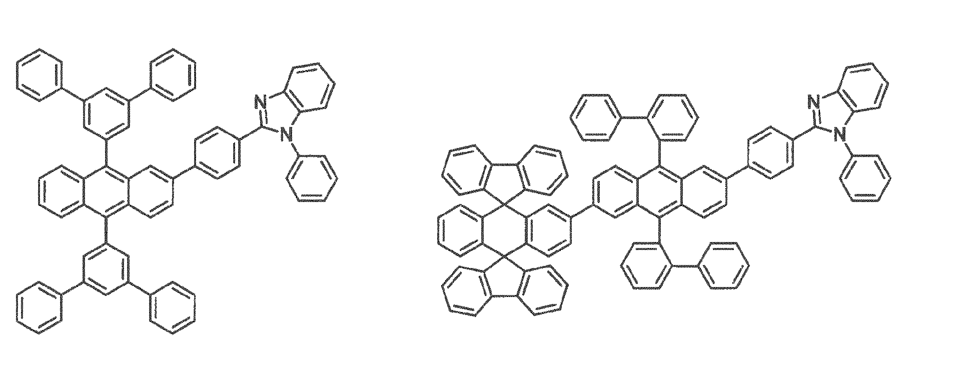

5. Dispositif organique électroluminescent selon la revendication 1, dans lequel les halogénures de métaux sont sélectionnés parmi LiF, MgF₂, NaF et KF.

6. Dispositif organique électroluminescent selon la revendication 1, dans lequel le matériau de transport d'électrons est un composé de la Formule suivante et les halogénures de métaux sont des LiF :

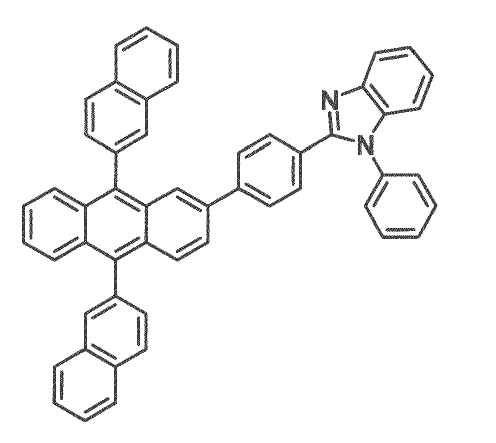

7. Dispositif organique électroluminescent selon la revendication 1, dans lequel les halogénures de métaux sont inclus en une quantité comprise dans la plage de 1 à 50 % en poids par rapport au poids total d'un matériau de la couche de matériau organique contenant des halogénures de métaux.

8. Dispositif organique électroluminescent selon la revendication 1, dans lequel une couche d'injection d'électrons est positionnée entre l'une quelconque de la première électrode et de la deuxième électrode et de la couche de matériau organique, y compris d'un matériau de transport d'électrons dopé d'halogénures de métaux.

9. Dispositif organique électroluminescent selon la revendication 1, dans lequel la couche de matériau organique comprend une couche de matériau organique de type n en contact avec une électrode de la première électrode et de la deuxième électrode et une couche de matériau organique de type p qui forme une jonction NP avec la couche organique de type n et les niveaux d'énergie des couches satisfont les expressions suivantes (1) et (2) : ${E}_{nL} - {E}_{F ⁢ 1} ≦ 4 eV$ ${E}_{pH} - {E}_{nL} ≦ 1 eV$
dans lesquelles E_{F1} représente un niveau d'énergie Fermi de l'électrode, En représente un niveau d'énergie LUMO de la couche de matériau organique de type n et E_{pH} représente un niveau d'énergie HOMO de la couche de matériau organique de type p formant la jonction NP avec la couche de matériau organique de type n.

10. Procédé de production d'un dispositif organique électroluminescent, comprenant les étapes consistant à :
former une première électrode ;
former au moins une couche de matériau organique comprenant une couche électroluminescente sur la première électrode ; et former une deuxième électrode sur la couche de substance organique,
dans lequel au moins une couche du matériau organique comprend un matériau de transport d'électrons dopé d'halogénures de métaux et le matériau de transport d'électrons est le composé comprenant le groupe fonctionnel sélectionné parmi le groupe constitué d'un groupe imidazole, d'un groupe oxazole et d'un groupe thiazole ; le composé ayant un groupe quinoline ; ou le composé répondant à l'une des formules chimiques suivantes, 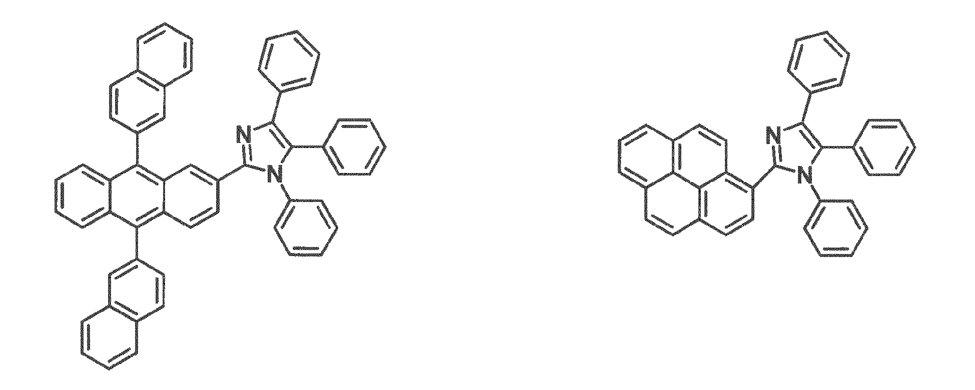 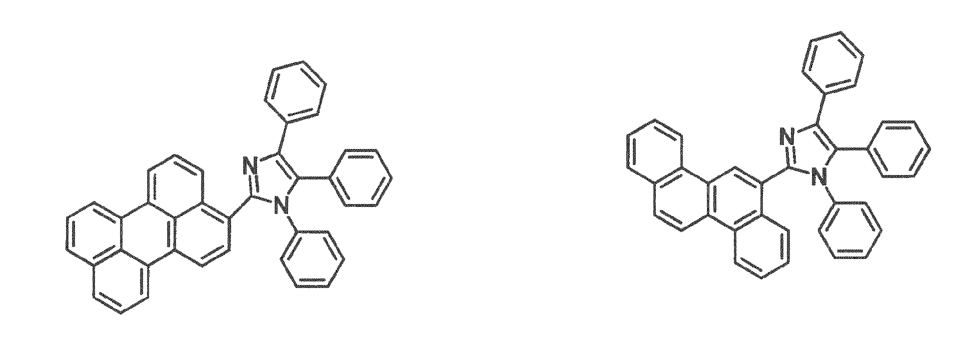
et dans lequel le composé comprenant le groupe fonctionnel qui est sélectionné parmi le groupe constitué du groupe imidazole, du groupe oxazole et du groupe thiazole est un composé répondant à la Formula 3 suivante, et le composé contenant le groupe quinolone est sélectionné parmi les composés des Formules 5 à 11 suivantes : 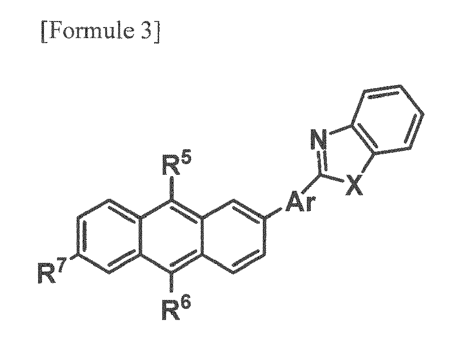
dans laquelle formule R⁵ à R⁷ sont identiques ou différents l'un de l'autre, représentent chacun indépendamment un atome d'hydrogène, un hydrocarbure aliphatique en C₁ à C₂₀, un cycle aromatique, un hétérocycle aromatique ou un cycle aliphatique ou aromatique condensé ; Ar représente une liaison directe, un cycle aromatique, un hétérocycle aromatique ou un cycle aliphatique ou aromatique condensé ; et X représente O, S ou NRₐ, Rₐ représente un atome d'hydrogène, un hydrocarbure aliphatique en C₁ à C₇, un cycle aromatique ou un hétérocycle aromatique, à la condition que R₅ et R₆ ne peuvent pas représenter simultanément un hydrogène, 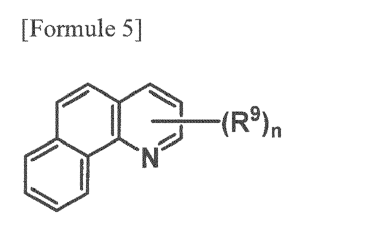 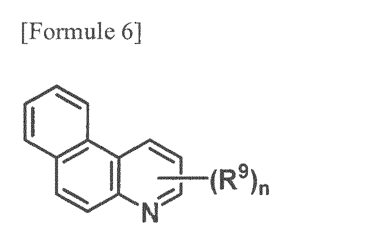 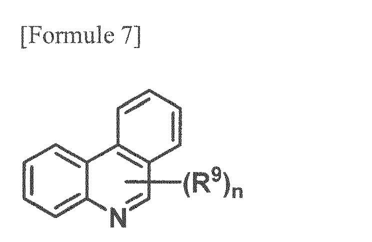 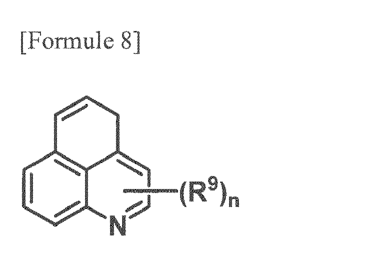 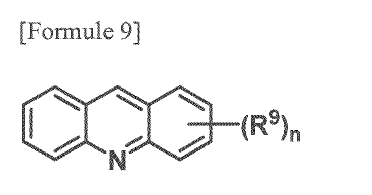 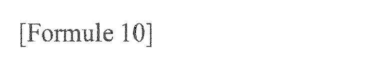 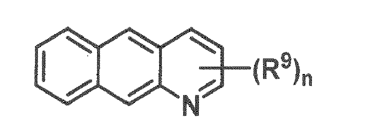 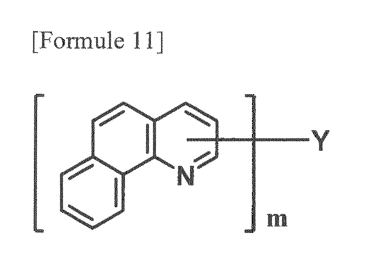
dans lesquelles formules n représente un entier compris dans la plage de 0 à 9, m représente un entier compris dans la plage de 2 ou plus, R⁹ représente un composé sélectionné parmi le groupe constitué d'un hydrogène, d'un groupe alkyle, d'un groupe cycloalkyle, d'un groupe aralkyle, d'un groupe alkényle, d'un groupe cycloalkényle, d'un groupe alcoxy, d'un groupe alkylthio, d'un groupe aryléther, d'un groupe arylthioéther, d'un groupe aryle, d'un groupe hétérocyclique, d'un halogène, d'un groupe cyano, d'un groupe aldéhyde, d'un groupe carbonyle, d'un groupe carboxyle, d'un groupe ester, d'un groupe carbamoyle, d'un groupe amino, d'un groupe nitro, d'un groupe silyle, d'un groupe siloxanyle et d'une structure cyclique qui est formée en conjonction avec un groupe adjacent ; les groupes de substituants susmentionnés peuvent être non substitués ou substitués, et les groupes de substituants susmentionnés sont identiques ou différents les uns des autres lorsque n vaut 2 ou plus, et
Y est un groupe ayant une valence égale à 2 ou plus des groupes R⁹ susmentionnés.
